Europäisches Patentamt

European Patent Office

Office européen des brevets

(11) Publication number: **0 467 437 A1**

# EUROPEAN PATENT APPLICATION

(21) Application number: **91201677.1**

(22) Date of filing: **29.06.91**

(51) Int. Cl.5: **H01F 7/02, G01R 33/38**

(30) Priority: **16.07.90 IT 2095190**

(43) Date of publication of application:
**22.01.92 Bulletin 92/04**

(84) Designated Contracting States:
**BE CH DE ES FR GB LI NL SE**

(71) Applicant: **ESAOTE BIOMEDICA SpA**
**Via Siffredi, 58**
**I-16159 Genova(IT)**

(72) Inventor: **Bertora, Franco**
**Via Trento 41/12A**
**I-16145 Genova(IT)**
Inventor: **Trequattrini, Alessandro**
**Via San Nazaro 4/12**
**I-16145 Genova(IT)**
Inventor: **Pan, Antonio**
**Via Peradori 10**
**I-26013 Crema(IT)**
Inventor: **Pan, Paolo**
**Via Peradori 10**
**I-26013 Crema(IT)**

(74) Representative: **Incollingo, Italo**
**Piazzale Lavater, 3**
**I-20129 Milano(IT)**

(54) **Finite length magnets for MRI applications.**

(57) Permanent magnets generating uniform magnetic fields, particularly for MRI applications, according to the invention, comprise an internal cavity and prismatic elements of magnetic and non magnetic material, with the characteristic of having the locus of zero magnetostatic potential points consisting substantially of at least one rectilinear line segment cutting the transverse section of the cavity at pre-determined positions. The thickness or density of the magnetic material can be zero in at least one of the points in which said segment meets the cavity boundary.

The corresponding bi-dimensional finite length magnets built through the assembly of at least thin slices of magnetic material having magnetization intensity (J) which varies along an axis (z,u) in such a way to null at least one of the terms of the series expansion of the magnetostatic potential or of an equivalent description of the field.

EP 0 467 437 A1

Rank Xerox (UK) Business Services

Fig. 1

EP 0 467 437 A1

The invention applies to magnets, preferably yoked, having an internal cavity and prismatic elements of magnetic and non magnetic material which generate, inside the cavity, an uniform magnetic field and distribute the locus of the points having zero magnetostatic potential along a straight line segment.

The invention also comprises the related finite length magnets, as well as the fabrication method of said magnets, and the methods of reduction of their length to a finite value.

As it is well known MRI permanent magnets (or, in general, permanent magnets producing a uniform magnetic field) may be:

a) three-dimensional: the magnetic material distribution is such that it generates a uniform field inside a cavity which, however, must be closed.

b) mono-dimensional: the magnetic material distribution and the cavity where the uniform field exists are defined in a single direction z and extend infinitely in directions x and y. They cannot therefore exist in practice, unless in finite dimension approximations as, for example, those magnets which consist of an iron (or other high permeability material) magnetic circuit having two pole pieces of varied shapes (square, circular, etc.) between which there exists a field oriented, at least at the center, perpendicularly to the pole pieces themselves. Some method to limit the effect of the truncation to finite dimensions in the x and y directions on the field homogeneity are described in the USA Patents 4,675,609 (Fonar) e 4,679,022 (Sumitomo).

c) two-dimensional, i.e. cylindrical structures obtained assembling elements which are infinitely extended in the z direction and obtained by "extrusion" from plane figures laying in the x-y plane; also the lines of force of the magnetic field lie in the x-y plane. They can, in turn, be:

- i) yoked
- ii) yokeless
- iii) hybrid

Magnetic Resonance devices require intense (sensibility is, at least up to about 1 T, an increasing function of field intensity), and homogeneous (in the order of 100 ppm) fields over volumes which strongly depend on sample dimensions.

Since most of the techniques currently employed resort to time-varying magnetic field some degree of transparency to them is highly desirable. Conversely, when it comes to static or slowly-varying external magnetic fields some opacity might be desirable, having some screening effect against outside perturbations.

i) In yoked magnets any iron yoke completely clads the magnetic material in the x-y plane. The purpose of the yoke is the closure of the flux lines and their confinement within the structure.

Yoked magnets can achieve an high "efficiency" value is defined as the ratio between the energy of the magnetic field generated in the magnet cavity and the energy stored in the magnetic material, it can be, for particular configurations, very close to the absolute maximum (0.25).

The presence of the iron cladding around the cavity makes the structure non transparent to static and time-varying magnetic fields.

ii) in yokeless magnets both the generation and the confinement of the field are obtained employing triangular prismatic elements of permanently magnetized material.

If an insulating material, like ferrite, is employed for their construction they turn out to be completely transparent both to static and to time-varying magnetic fields. I a conducting material (like a NdFeB alloy) is employed they are transparent to static but not to time-varying magnetic fields.

The confinement of the field is obtained forcing the flux lines to close in paths which are contained within the structure itself, thus not requiring the use of any high permeability material but increasing the amount of permanently magnetized material employed.

As a consequence yokeless magnets have an efficiency that reaches, at most, the 64% of the maximum value achievable.

From the manufacturing point of view they suffer the higher manufacturing cost deriving from an high number of magnetic material elements, which amounts, in general, to three times the number of the sides of the internal cavity.

iii) hybrid magnets constitute an intermediate category, since in these configurations the flux lines are guided and closed in part through permanently magnetized material elements and in part through a partial, high permeability yoke. The yoke is defined partial since, though still extending infinitely along the z axis, does not completely surround the cavity in the x-y plane.

They are characterized, with reference to yokeless magnet configurations, by the fact that part of the magnetic material which would have been employed in a yokeless magnet to guide and confine the field is here substituted by high permeability elements. In this way a higher efficiency can be achieved with a parallel reduction in the manufacturing costs, since the total number of magnetic material elements decreases.

## State of the art.

The theoretical design basis of two-dimensional, infinite length, yokeless and hybrid permanent magnets have been published in the works of Manlio G. Abele "Yokeless Permanent Magnets" - New York University TR 14, November 1, 1986 and "Design of Two-Dimensional Magnets without Magnetic Yoke" - New York University TR 15, March 1, 1987.

The particular theory of the design of two-dimensional, infinite length, symmetrical yoked permanent magnets has been published, still by Manlio G. Abele in the work "Optimum Design of Two-Dimensional Permanent Magnets - New York University TR 21, October 15, 1989 and the particular case of the two-dimensional, infinite length, yoked magnet having a square or hexagonal cavity comprising, at least, two right angles is described in the USA Patent n. 4,695,802 by H. Zijlstra.

Prior art does not comprise any device for designing an infinite length, two-dimensional yoked structure having an arbitrary shaped cavity.

Also extraneous to such prior art is the notion that, given an arbitrarily assigned cavity shape, there might be more than one possible solution to the problem of devising an infinite length, two-dimensional yoked magnet structure which produces an uniform field within that cavity and that, therefore, the final choice of the structure can be dictated by other optimality considerations.

Another relevant problem yet not solved in the prior art is that of reducing infinite length structures to finite length equivalents, which could be realized employing non ideal, commercially available materials and yet are capable of a prescribed level of performance in terms of uniformity of the generated field.

The first aim of the present invention is to provide a method for the production of permanent magnet, for example of type i), with adequate cavities. In fact no prior solution exists to the general problem of designing two-dimensional, infinite length yoked magnet around an arbitrary cavity. Particular solutions have been presented in the past but none of them addresses the problem of giving more than one alternative solutions over which one could be chosen on the basis of some external optimum criteria.

Another purpose of the invention is to render available a method for the production of two-dimensional magnets of finite length. In fact no systematic prior solution exists to the problem of reducing an infinite length, two-dimensional magnet constructed employing an abstract, ideal characteristics material to a finite length, manufacturable equivalent capable of assuring a prescribed level of uniformity of the generated field.

The most important characteristics of the method according to the invention, as of the resulting magnets are expressed in the claims which must be considered to be herewith included.

## Description of the drawings.

The different aspects and the advantages of the invention will appear from the description of the preferred, but not limitative, realization forms, represented in the enclosed drawings in which:
- Fig. 1 is a block diagram of the method according to the invention.
- Figs. 2 and 7a are schematic transverse sections of cavities, along with their relative possible lines LPN at zero potential;
- Figs. 3a, 3b, 5, 7a, 7b, 9, 10 are representations of the procedure to define the internal and external profiles, as determined by the graphical method in Figs. 4, 8, 11a, 11b
- Figs. 6a, 6b, 6c, 12a and 12b are schematic transverse sections of infinite length magnets;
- Fig. 13 represents, in a schematic perspective, the coordinate system employed.

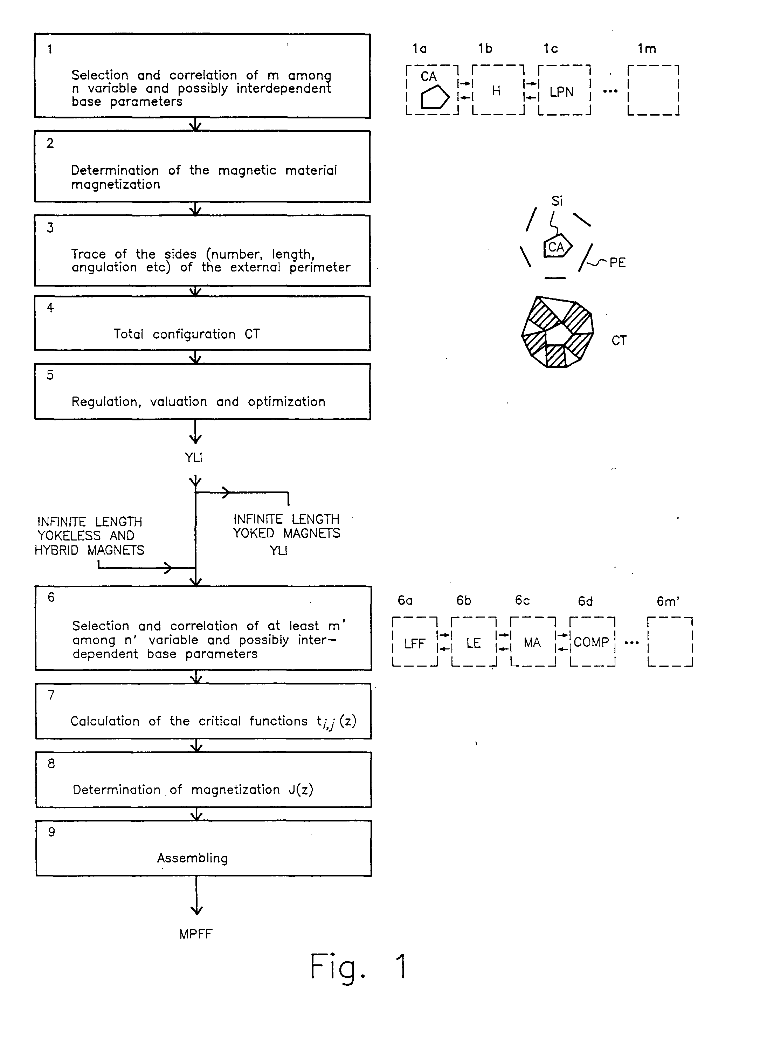

To facilitate the comprehension of the method according to the invention in Fig. 1 is represented, in the format of a block diagram, a particular realization specially advantageous and therefore preferred but not limiting.

In the initial stage 1 the initial assumptions are made: i.e. the selection and correlation of m among n basic parameters from $P_1$ to $P_n$. Among these parameters three at least have a fundamental importance: $P_1$ (cfr. 1a), the definition of the cavity CA; $P_2$ (cfr 1b), the value or intensity of the magnetic field $H_0$ within the cavity CA and; $P_3$ (cfr 1c), the zero potential line LPN. (Here the further parameters from $P_4$ to $P_m$ are willingly omitted to simplify the description).

In the stage 2 the magnetization of the magnetic material MgMM(J) id defined and in stage 3 the trace of the exterior boundary PE is defined or, better, the sides (number, length, orientation) are determined, for that CA cavity which has been selected in 1a.

In stage 4 we have the total configuration CT that, as can be seen on the side, results from the definition of the cavity CA, of the internal sides $S_i$ and of the external boundary PE. In stage 5 the evaluations and optimizations are performed.

At the output of stage 5 we have infinite length, preferably yoked, magnets YLI, some of which may immediately employed as such.

According to a substantial aspect of the invention the magnets YLI at the output of stage 5, as well as any other yokeless or hybrid magnet coming from the outside and stationed, for instance, in 18 are submitted to further operations and treatments to be reduced to finite length. The schematic of this subprocess (bottom part of Fog. 1) is substantially analogous to that in the upper part and comprises a stage 6 in which m' among n' basic parameters variable and possibly interconnected are defined. Among the m' parameters at least 3 are essential i.e.:

(6a) definition of the terminal finite length LFF of the magnet;

(6b) definition of the error level LE;

(6c) choice of the magnetic material MA; and, preferably but not necessarily

(6d) definition of a compensation structure.

In the stage 7 the m' parameters are elaborated and, employing, for instance, an adequate algorithm, the functions $t_{lm,i}(z)$ [3o], critical and typical of the method of the invention are derived.

In the following stage 8 the magnetization distribution $J(z)$ of the magnetic elements and components and of the possible compensation elements, and, finally, in stage 9 the assembly of said elements as before determined yields finite length permanent magnets (yoked, yokeless or hybrids) MPFF.

## Detailed description

The general problem of the definition of a bi-dimensional magnetic structure, capable of generating a uniform field within a cavity having a preassigned arbitrary shape does not have a unique solution. Given any arbitrarily shaped cavity CA there exist an infinite number of possible solutions, out of which to make a choice, (phase 1a) based on some set of externally established optimum criteria.

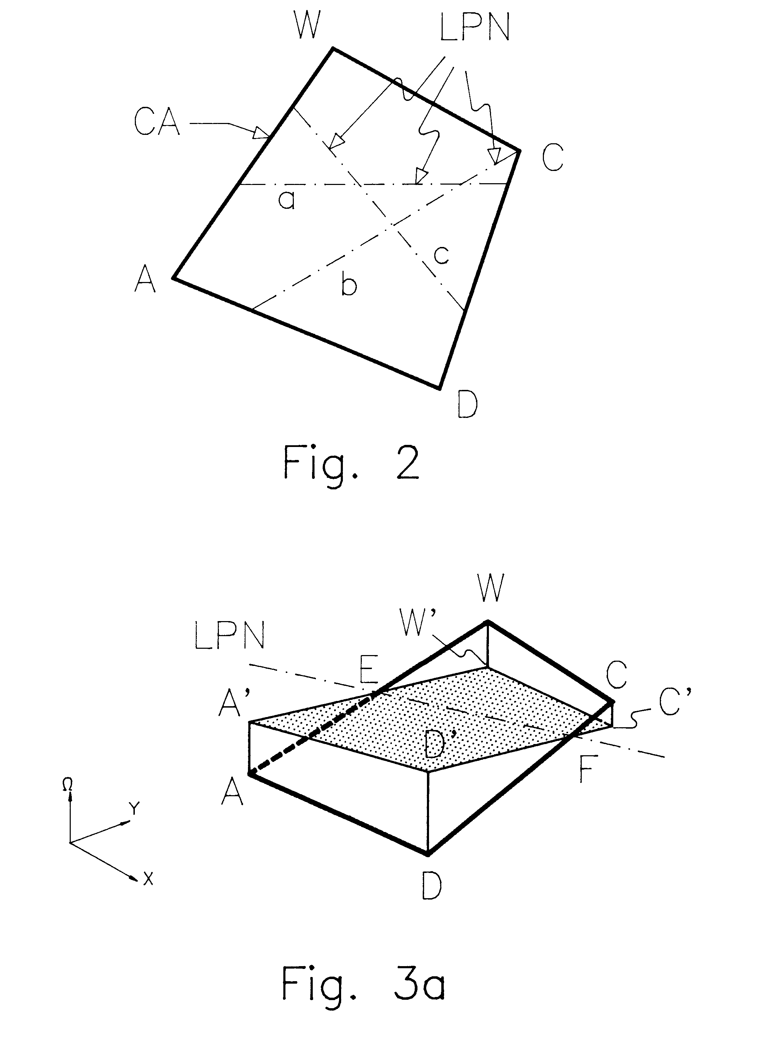

According to a relevant aspect of the invention the design process starts with the choice of a line of zero magnetostatic potential, (LPN) crossing both the cavity (CA) and the surrounding structure, and on the fact that the location of this line within the cavity can be arbitrarily chosen, as shown in fig. 2.

Consider now the magnetostatic potential $\Omega$ which, since we are dealing with two-dimensional structures, will only be function of coordinates $x$ and $y$ defined on a plane perpendicular to the axis $z$ of the magnet. Since the field $H_0$ within the cavity CA (delimited, for example, by A, W, C, D in fig. 2) is supposed to be uniform it then follows that the potential function $\Omega$ will be represented by a plane, for instance A', W', C', D' in fig. 3a, resting on the zero potential line LPN which encounters the boundary of the cavity CA for example in points E, F. The slope of the plane A', W', C', D' with respect to the xy plane represents its gradient and determines the intensity of the field, which will be expressed in the following as a function of the design parameter K:

$$H_0 \ = \ J_0 \ K$$

Imposing now the requisite that the magnetization J is uniform and (at least in the xy plane) constant in any of the elements composing the structure it then follows that the magnetostatic potential function $\Omega$ is represented by plane surfaces everywhere and, therefore, also within the magnetized material.

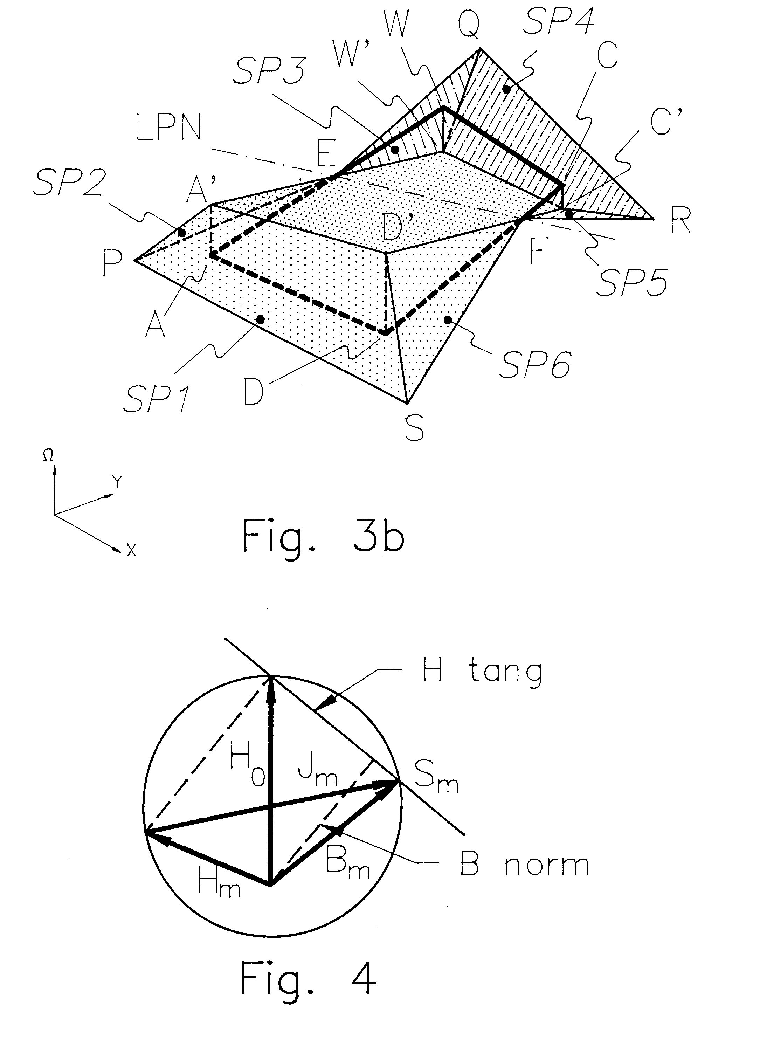

According to an aspect of the invention a simple and preferred solution to the problem consists in finding the intersections of the zero-potential xy plane with the plane surfaces Spi representing the magnetostatic potential within the magnetized material regions. These surfaces $Sp_i$ rest, as it is shown in fig. 3b, on the edges of the polygonal surface representing the potential within the cavity CA and slope upwards or downward at an angle (yet to be determined) to meet the zero-potential xy plane. The intersections thus found define a zero-potential line and determine, at least partially the shape of the yoke GIO (not shown in the figure) enclosing and delimiting the magnetic material regions. In said Fig. 3b the surfaces from Sp1 to Sp6 are defined, respectively by points S D' A' P, P A' E, E W' Q, Q R W' C', R C' F, F D' S and said intersection lines with the zero-potential plane are represented by segments S P, P E, E Q, Q R, R F, F S. In Fig. 4, which represents graphically the relationship;

$$B \ = \ \mu_0 H \ + \ J$$

between the magnetization J, the induction B and field H within any one of the elements (MM) of magnetic material, the orientation of the magnetization J in any of said elements MM is determined (bold symbols denote vectors, normal typeface their modulus).

In Fog. 3b the intersections of plane surfaces Spi, representing the magnetostatic potential within the magnetized material regions, define part of the external profile (phase 3) of the magnet, since, being themselves lines of zero magnetostatic potential, they can be substituted by a medium having infinite or very high permeability.

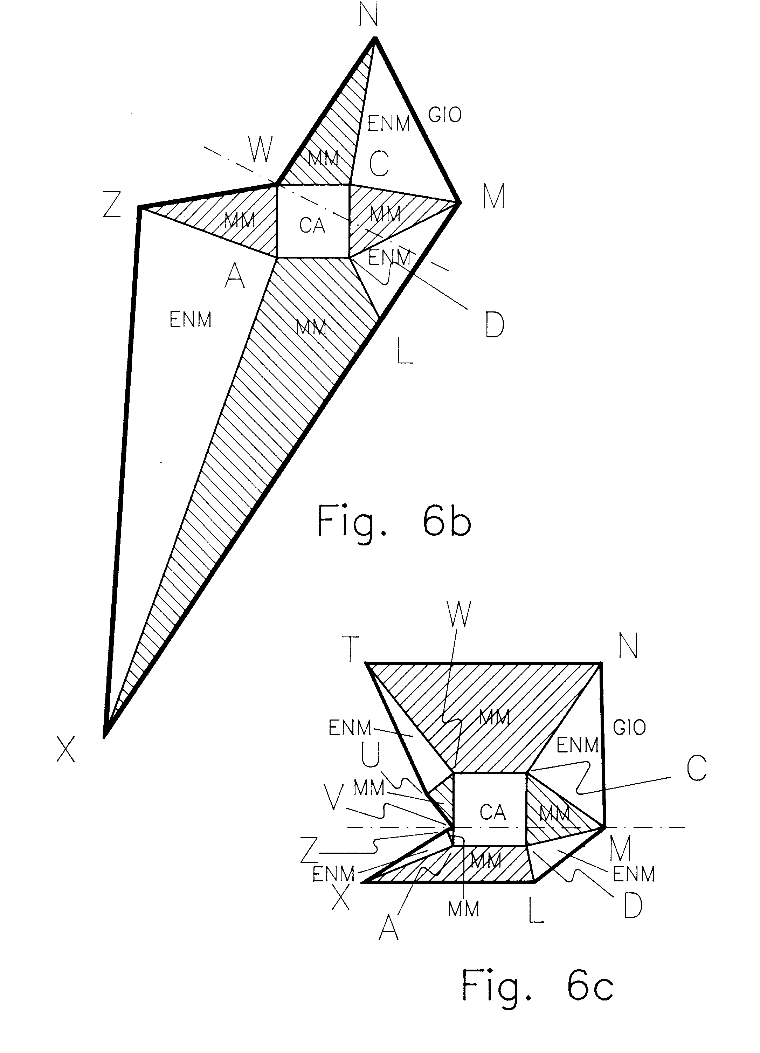

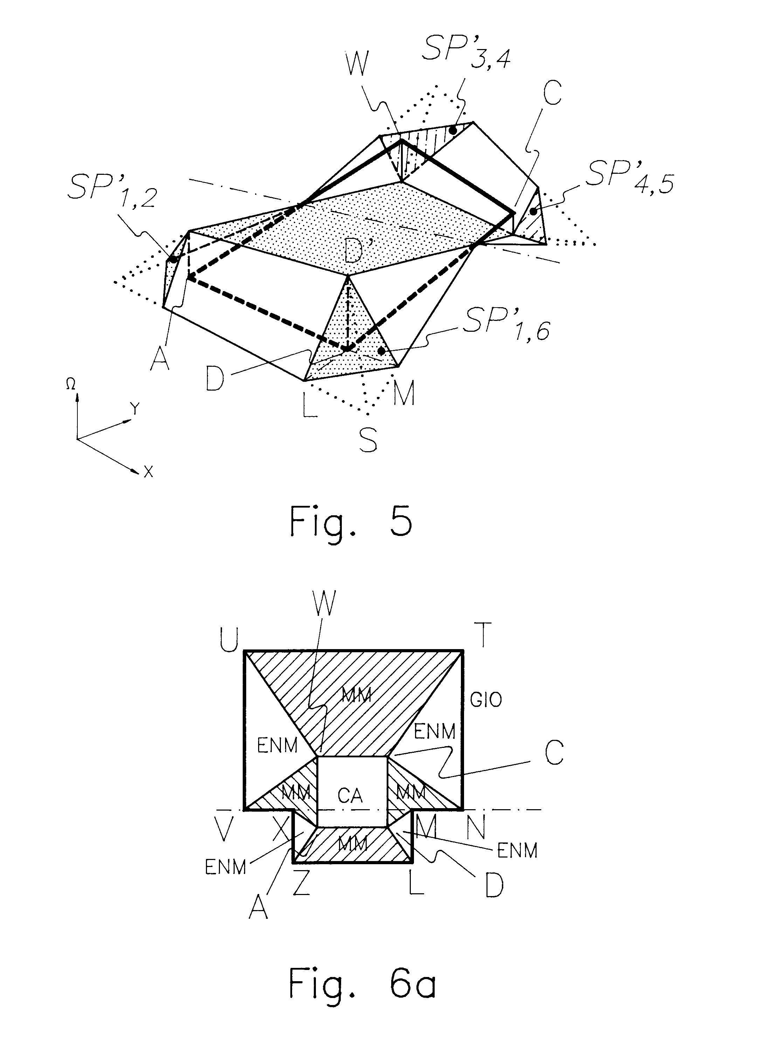

There will, however, be intersection lines (as line D' S inf Figs. 3b and 5) between planes representing the potential function in adjacent regions of magnetic material along which the continuity conditions for vectors B and H are not satisfied. According to a further aspect of the invention these incoherences can be removed with the introduction (for example in phase 5 of Fig. 1) of elements ENM of non magnetic material between any pair of adjacent magnetized material regions MM (Fig. 6a, b c). In this way the contact points between magnetized material regions reduce at most to a single point per pair and the continuity conditions may be satisfied.

The boundaries of these non magnetized regions (corresponding, in Fig. 5 to the polygon L M D) are so chosen that they satisfy the continuity conditions and therefore define as many more plane surfaces $SP'_{rs}$ identifying the magnetostatic potential function (here, obviously, $J = 0$ and therefore $B = \mu_0 H$). The intersection (e.g. L M in Fig. 5) of these further planes with the zero potential xy plane completes the definition of the shape of the elements of magnetized material and of the exterior shape of the magnet, giving the complete profile of the yoke GIO of high permeability magnetic material. By way of example Figs. 6a, 6b, 6c show three possible magnet configurations built around the same cavity and corresponding to different choices of the line LPN at zero magnetostatic potential and of the shapes of the magnetized material regions and of the corresponding elements ENM of non magnetized material. In order not to complicate the drawing in Fig. 5 only polygon L M D is identified, even if, obviously, the number of non magnetized material polygonal regions is, in general, more than one.

In the following some considerations on particular aspects and phases of the process are exposed, according, by way of example, to Fig. 1.

1a) Cavity

The first step of the design consists in defining the shape of the transverse section of the cavity of the bi-dimensional magnet. The cavity can have any arbitrary shape as long as it is polygonal. I a non-polygonal form is needed it will be necessary to approximate it, to the desired degree, with a polygonal profile.

1b) Magnetic field within the cavity CA

The next step will be the setting of the desired value for the uniform magnetic field within the cavity. The value may be chosen at will, provided it is below the value of the remanence J0 of the material which is going to be employed for the construction. On the basis of the chosen value for the magnetic field the design parameter K is determined, according to the following definition:

$$K = H_0/J_0$$

It is evident from the definition that K will always be comprised between 0 and 1.

1c) Position of the zero magnetostatic potential line within the cavity

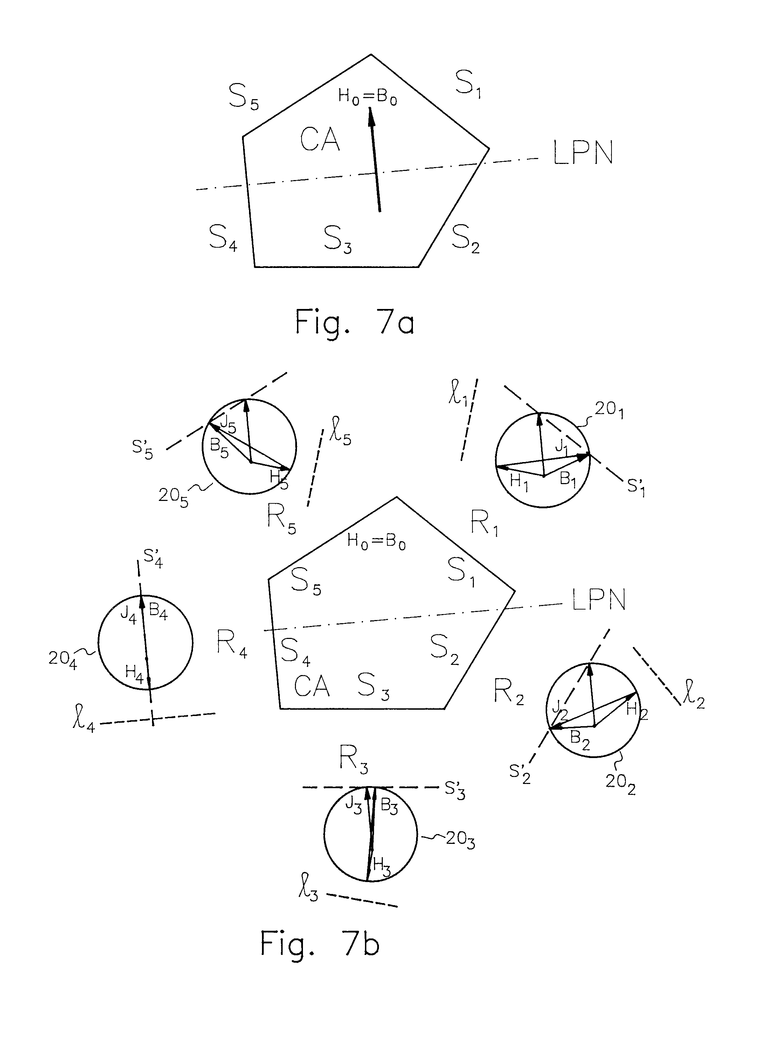

It is now necessary to choose the straight segment which will become the locus LPN of the zero potential points within the cavity. Since the choice is largely arbitrary, as the preceding ones, it can be effected on the basis of a generic optimum criterion which cannot be defined now that only an example is considered. Fig. 7a resumes the status of the process after the first three steps 1a, 1b and 1c.

It is now necessary to define the profile of the magnetized material elements and the direction and the intensity of the magnetization J, of the magnetic field H and of the induction B in any one of the sections of the magnet. This will be the subject of the following steps.

2) Determination of magnetization in the magnetic material elements.

In the current example we assume, for the sake of simplicity, to utilize a constant polarization J0 (modulus of J) material. The procedure which is being described is, however, immediately extensible to the use of materials having different polarizations J. The effect of deviations from unit permeability will be examined later.

The direction and the modulus of the vectors B, H and J in the region of magnetic material which is adjacent to any side of the boundary of the internal cavity can be computed by means of the circular diagram, shown in Fig. 3, which is constructed as follows:

- Draw circle (20) of diameter J0.
- Assume that the field inside the cavity is represented (except by a scale factor $\mu_0$) by the segment A-$N_0$ passing through the center O of the circle and drawn parallel to the direction of H0 and with a length equal to K*J0.
- Draw segment $N_0$-$N_1$, parallel to $S_1$. Dra also the diameter passing through point $N_1$, and the two segments A-$N_1$ and A-B.

It is now easy to see that, if segment B-$N_1$ is associated with vector J, segment A-B with vector H and segment A-$N_1$ with vector B, the diagram determines in a unique way vectors $H_1$, $B_1$ (and, as a consequence, $J_1$) that satisfy the continuity conditions for the tangential component of H and for the normal component of B at the interface between the magnet internal cavity and the magnetized material in the region beyond side $S_1$.

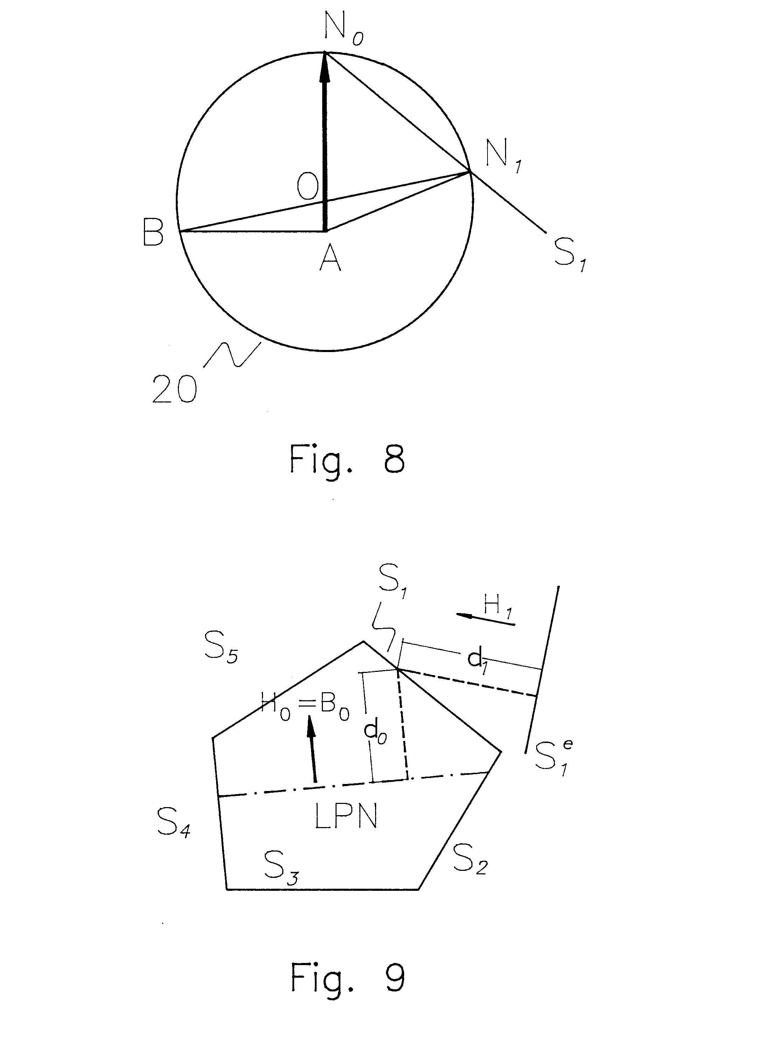

According to an aspect of the invention the same procedure, repeated for each and any of the sides $S_1$ - $S_m$ which delimit the internal cavity, conduces to the determination of vectors $B_1$ - $B_m$, $H_1$ - $H_m$ and $J_1$ - $J_m$ in the magnetic material regions adjacent to each and any side of the cavity, thus arriving to the situation depicted in Fig. 7b, in which, in analogy with Fig. 8 referred to a generic side, the circle ($20_1$) relative to side $S_1$, to which line $S'_1$ is parallel. $J_1$, $H_1$, $B_1$ are therefore determined, as in Fig. 8. In a similar way circles from ($20_2$) a ($20_5$) allow the determination of the relative $J_i$, $H_i$ e $B_i$. The magnetized material regions $R_1$ - $R_m$ will therefore limited, among other, by the sides $S_1$ - $S_m$ and by lines oriented perpendicularly to the vectors $H_1$ - $H_m$, exemplified in Fig. 7b by lines $I_1$ - $I_5$. It is now necessary to define the remaining sides which delimit the regions of magnetic material and the profile of the high permeability yoke (GIO).

3) Definition of the external profile of magnetized material.

In order to proceed with the determination of the remaining sides which delimit the magnetic material regions it is necessary to distinguish two cases, according to wether the magnetic material region is or not adjacent to a side of the internal cavity which is crossed by the zero potential line LPN chosen in step 1c.

If a side S1 of the cavity is not touched by the zero potential line LPN (or if it is touched only at one of its extremities) the potential value along the side will always have the same sign, positive or negative, (with the possible inclusion of the zero value). Since the potential function within the material can be represented by a plane Spi, whose inclination is fixed by the value of H it then follows the existence of a zero potential line which does not cross the cavity side (at most touching it at one of its extremities) and which represents, at the same time, the boundary of that region Ri of magnetic material and as part of the yoke GIO boundary.

There are many possible ways to determine the position of this external boundary line $S^e_i$ but all can be conduced to an application of the circuitation law. A preferred solution is as follows: since intensity and direction of the H vector inside the cavity and inside the magnetic material are, by, now known it is possible, having chosen a point on the zero potential line within the cavity, to determine a point of the zero potential line within the material by applying the relationship:

$$H_0 \, d_0 = H_1 \, d_1$$

in which $H_0$ ed $H_1$ represent the modulus of the H vector respectively within the cavity and within the material and $d_0$ and $d_1$ represent the distances measured along the direction of the H vector, of the cavity side from the two zero potential lines: internal and external.

The procedure described above is presented in Fig. 9 and conduces to the determination of line $S^e_1$ which represents, at the same time, a boundary of the magnetic material region and an element of the profile of the enclosing yoke GIO (not shown).

4) Determination, employing the circular diagram, of a possible configuration of the shapes of the non magnetic material elements and consequent completion of the definition of the external profile of the magnetized material elements and of the yoke.

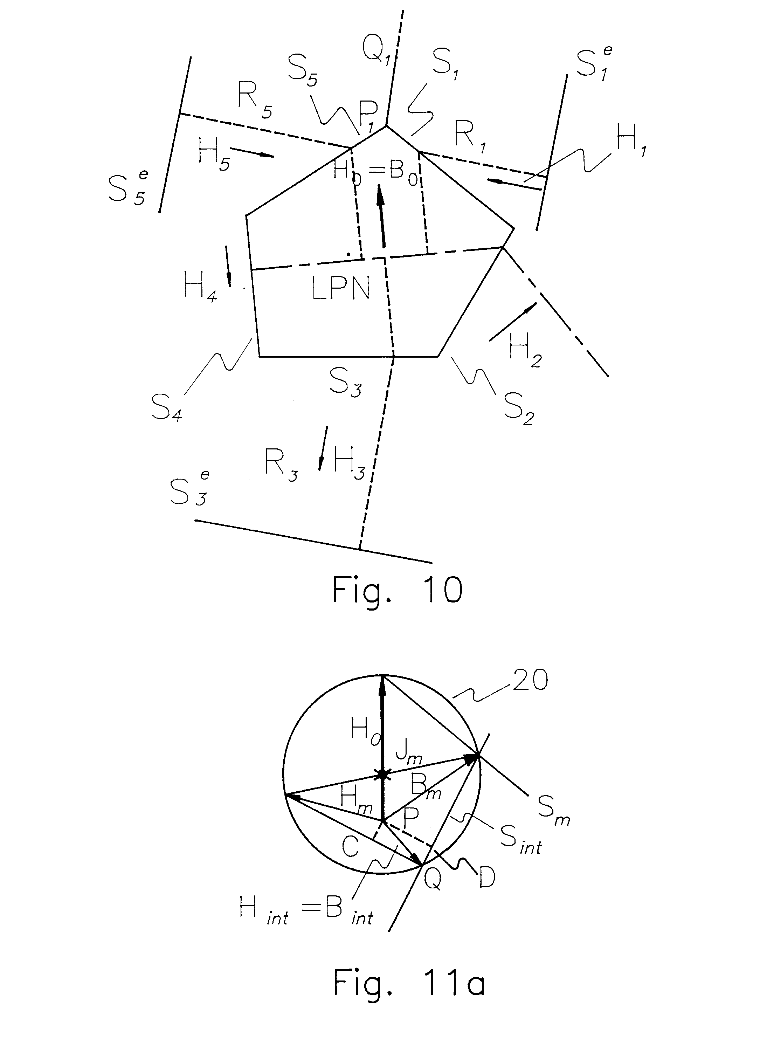

By repeating the procedure described in the preceding section 3 for all the sides of the internal cavity which are not crossed by the zero potential line one arrives at the partial definition of the external profile of the magnet, as shown in Fig. 10. Notice however that if the magnetic material regions which insist on adjacent sides of the polygon representing the cavity (as, for instance, regions R1 and R5 in Fig. 10) were put into direct contact, by way of example along line $P_1$-$Q_1$, continuity conditions for the tangential component of H and normal component of B would not be satisfied.

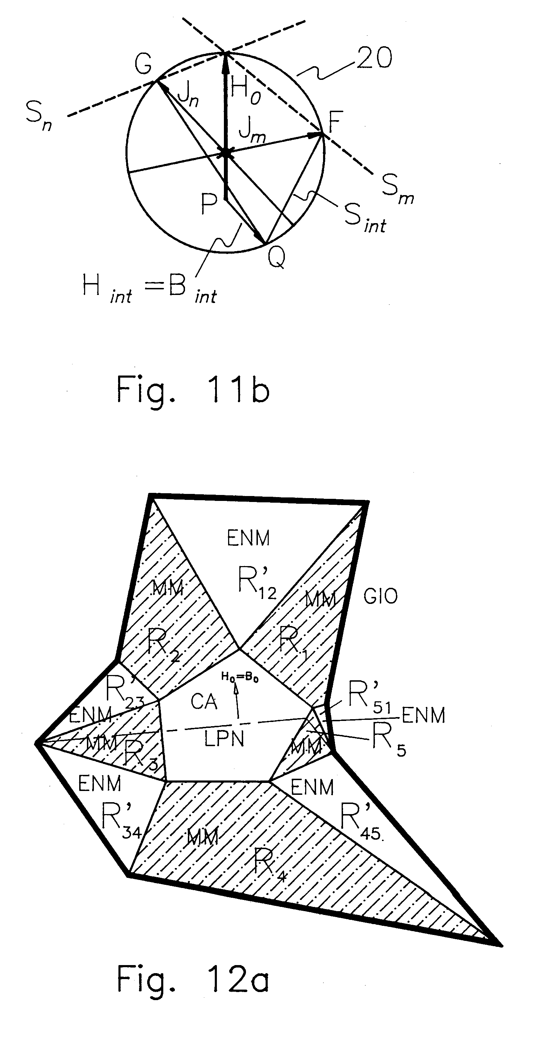

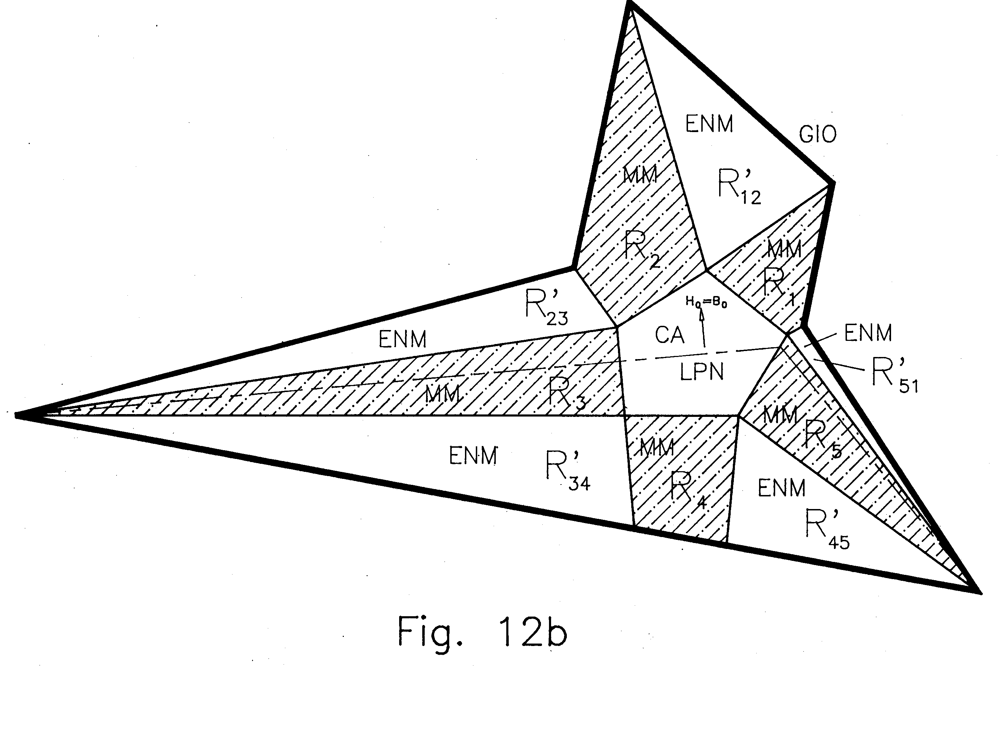

It is therefore necessary to introduce between any pair $R_i$ $R_j$ of magnetic material regions (see, for instance, pairs $R_1$ $R_2$, $R_2$ $R_3$, $R_3$ $R_4$, $R_4$ $R_5$, $R_5$ $R_1$ which, in Figs. 12a and 12b, insist on adjacent sides of the polygon representing the cavity) non magnetic material regions $R'_{ij}$ ($R'_{12}$, $R'_{23}$ $R'_{34}$, $R'_{45}$ and $R'_{51}$ in said Figs. 12a and 12b) to allow for the conservation of continuity conditions for vectors B and H. These non magnetic material regions must, in turn, interface without prejudice for the continuity conditions, with the remaining sections, still to be defined of the enclosing yoke. As it will be clear later the method which will be employed for the solution of these problems will also be applicable to the definition of the sides bordering the magnetic material regions adjacent to the cavity sides and crossed by the zero potential line, when the thickness of the magnetic material is desired to be zero where said line LPN crosses the cavity boundary. Fig. 6c shows one of these cases, in which the thickness of the magnetic material is zero at point V.

From what it has been said above it appears that any of these non magnetic material regions $R'_{ij}$ must interface with the two magnetic material regions $R_i$ and $R_j$ and with yoke GIO (see, for example, Figs. 12a and 12b). Since the yoke is delimited, by definition, by a zero potential line, and since the region to be defined is made up of non magnetic material ($J = 0$), it then follows that the boundary between this region and the yoke GIO is represented by a line perpendicular to the direction of vectors B and H (which coincide a part from factor $\mu_0$) in the region itself. It is at the same time evident that the non magnetic material region $R'_{ij}$ will be delimited by at least three sides (one for each of the magnetic material regions $R_i$ and $R_j$ and one for the yoke GIO): the problem is thus conduced to the determination of the orientation of the line separating a magnetic material region from a non magnetic material region and determining there vectors B and H having a prescribed direction.

The solution to the above problem can be preferably determined making use, again, of the circular diagram. Refer to Fig. 11a which shows the circular diagram relating to the determination of the values of B, H and J in the region $R_m$, adjacent to side of orientation $S_m$ of the cavity CA.

Let's choose an arbitrary orientation for the boundary between the magnetic and non magnetic material regions. Trace a line $S_{int}$ having the chosen orientation through the intersection point between the circle and line $S_m$, parallel to the side of the internal cavity (and, therefore, through the "tip" of vector $J_m$). It can be easily be seen that the dashed lines P C and P D represent the projections of vectors $B_m$ and $H_m$ on the interface between the magnetic and non magnetic material regions. The resulting vector, from point P to point Q of intersection between line $S_{int}$ and circle 20, represents vectors $B_{int}$ and $H_{int}$ in non magnetic material region $R'_{mn}$.

Conversely, given vector $H_{int}$ (and $B_{int}$), which defines the field in non magnetic material region $R'_{mn}$, the boundary line between it and magnetic material region $R_n$ is defined by the direction of the segment joining the "tip" of such vector and the "tip" of vector J in the non magnetic material region.

If the circular diagrams relative to two magnetic material regions which insist on adjacent sides of the cavity are superimposed, as in Fig. 11b, the definition of the non magnetic material region $R'_{mn}$ to be interposed as an interface between the two is made by choosing an arbitrary point Q on circle 20 and drawing, from there, two segments connecting the "tips" F and G of vectors $J_m$ and $J_n$ in the magnetic material regions $R_m$ and $R_n$. These segments Q F and Q G represent the orientation of the boundaries between non magnetic and magnetic material regions; The three regions will have a common point at the junction between the two adjacent sides of the cavity. The segment connecting point Q, chosen before, with point P ("tail" of vector $H_0 = B_0$ inside the cavity) represents the direction of vectors $B_{int}$ and $H_{int}$ in the non magnetic material region: it therefore determines the direction perpendicular to the boundary between the non magnetic material region $R'_{mn}$ and the enclosing yoke GIO. This boundary will be determined by the line passing through the zero potential point of the boundary of the magnetic material region and perpendicular to the direction of $B_{int}$ and $H_{int}$.

The procedure which has been described allows also the determination of the boundaries of the regions, adjacent to the sides of the cavity, which are crossed by the zero potential line. In this case the zero potential line inside the material cannot be taken as a delimitation of the magnetic material region and the portion of boundary between it and the enclosing yoke reduces to a single point of which it can only be said that it must lie on the zero potential line. The magnetic material region will therefore have a triangular shape, with the two sides which do not insist on the cavity determined by the satisfaction of the continuity conditions on B and H at the interface between the cavity and the adjacent non magnetic material region, according to the procedure described above.

There might exist the particular case where, being one side of the cavity crossed by the zero potential line, it is desirable to reduce to zero the thickness of the structure at that point, as shown, by way of example, in Fig. 6c. It will in this case be necessary to consider that side of the cavity which is crossed by the zero potential line as made up of two distinct and collinear sides, having in common point V of contact with the zero potential line. The application of the same procedures described above allows one to determine the boundaries of the magnetic material regions, thus determining a non magnetic material region having triangular shape and a vertex in zero potential point V, and therefore external to the yoke.

The next step is the (initially arbitrary) choice of a direction for the boundary between a magnetic material region and the adjacent non magnetic material region.

As a consequence of this choice, and proceeding preferably in a clockwise or counterclockwise fashion around the cavity, one arrives to the complete determination of all the boundaries which were still missing to complete the definition of the structure and of the yoke.

5) <u>Evaluation</u> <u>and</u> <u>optimization</u> <u>of</u> <u>the</u> <u>choices</u> <u>made</u>.

The solution which has been found with the above procedure is a consequence of the choices made about the direction of the boundary between the pairs of magnetic and non magnetic material regions. It is therefore evident that other solutions exist, among which a choice can be made according to some optimality criterion which cannot be detailed here, since it is defined by external conditions related to the type of application sought. Figs. 6a, 6b and 6c, as also Figs. 12a and 12b show, by way of example of the flexibility of the method, two different solutions, corresponding to two different choices.

**Final result**

The final result of the procedure described above according to the invention enable the construction of a bi-dimensional permanent magnet generating a uniform magnetic field within the desired cavity, having a prescribed allocation of the zero magnetostatic potential line and chosen, according to an optimum criterion among an infinite number of possibilities. The magnet design thus obtained is bi-dimensional: therefore capable of giving the desired performance only if realized with a length which is sensibly greater than the transverse dimension. The necessary length will, in practice, be determined by the degree of homogeneity required by the particular application.

In the following sections the problem of the realization of limited length magnets but still capable of assuring the desired performance level is addressed, even in presence of imperfections in the magnetic material behavior, with respect to the ideal case.

**Magnetic material characteristics**

Some magnetic material parameters are particularly relevant to the practical implementation of the magnet configurations described above. They are the values of remanence, coercive force, susceptivity and rigidity (i.e. anisotropy degree).

Remanence, coercive force and susceptivity are the three parameters which depend on the shape of the magnetization characteristic in the second quadrant, which should, ideally, be represented by a straight line of unitary negative slope, if the same scale is used for B and for $\mu_0$ H. An ideal material has therefore a coercive force which is equal to remanence divided by $\mu$ and a zero susceptivity (corresponding to a $\mu = \mu_0$ permeability).

The material "rigidity" expresses its anisotropy degree i.e. the ratios between measures in the three principal directions of the above quantities. The ideal material has strong anisotropy: it has, therefore, high (and equal) values of remanence and coercive force along a specific direction (called the easy axis) and zero values in any direction orthogonal to the easy axis. Susceptivity of the ideal material is zero along any axis.

The following table shows the characteristic of some magnetic materials:

| material | reman. | coerc. fce | susceptivity | isot. |
|---|---|---|---|---|
| NiCo Alloys (ALNICO) | high medium-high | low low | high high | NO YES |
| Hard Ferrites | media | medium-high | low | NO |
| SmCo Alloys | high | high | low | NO |
| NdFeB Alloys (sintered) | high | high | low | NO |
| NdFeB Alloys (quenched) | high | high | low | YES |

As it can be seen a large selection of materials is available, all with their characteristics costs and properties, which must be taken into account in the magnet design process.

In particular, according to the specific type of configuration which has been chosen it will be necessary to determine the usable and non useable materials as a function of their characteristics. It has in fact to be remembered that some configurations are not applicable to isotropic materials, other exhibit high values of the demagnetizing field and require therefore high coercive field materials, while others still are particularly sensitive (for what it concerns the homogeneity of the field generated) to the susceptivity value of the material.

## Implementation related problems

The design problems to be solved are different and span from the choice of suitable methods for assembling the structure to those posed by the necessity of truncating it to finite length without significantly ruining the field uniformity. Further problems are posed by the choice of the material to be employed, as a function of the magnet geometry.

## Assembly

The analysis of the problems posed by the magnet assembly must start from a survey of commercially available shapes.

The magnetic material to be employed is, most of the time, a sintered material (ferrites, NdFeB and other Rare Earth alloys) and it is available in blocks having side dimensions of the order of a few inches, having the easy magnetization axis which is generally oriented perpendicularly to the most extended face of the block if this is made of ferrite and to the smallest in the NdFeB alloys case. A particularly simple and effective method of re-structuring elementary block to produce sub-assemblies for the subsequent assembly phases is described, by the same inventors A and P. Pan and F. Bertora in the Italian Patent application n° 21079A/89, whose description is assumed to be here included.

## Finite structure length

The structures so far dealt with are structures that, being two-dimensional, present scarce practical interest.

If a two-dimensional structure producing a uniform field is truncated to finite length the field generated will no more be uniform, the less so the shorter the truncated structure is with respect to the internal cavity dimensions.

A practical application of this category of magnets is therefore possible only if long structures are employed or if suitable compensations are applied to reduce the effects brought in by the reduced length of the magnet. USA Patent n° 4,695,802 mentions, without however disclosing any implementation detail the obvious and well known in the art possibility of effecting corrections by introducing magnetized or non magnetized materials in the vicinities of the magnet ends.

## Material characteristics

Permanent magnetic materials which are today commercially available have characteristics which very closely model the ideal characteristics postulated for by the design methods mentioned above. The requirements posed by an MR application are, however, so exacting that even the most minute deviations have to be taken into account if useable magnet is desired.

Anisotropy

In most cases examined so far the implicit assumption has been made that the material out of which the magnet has to be realized is perfectly anisototropic.

In fact in almost any of the structures which have been considered the direction of the magnetic field inside the material is not parallel to the direction of magnetization.

If the material is not perfectly anisotropic there will be a corresponding alteration in the orientation of the magnetization and this will bring about a field distortion, which will not any more be perfectly uniform.

High coercive force

If the intensity of the demagnetizing field present in the magnetic material, which depends on the geometry of the element and on the field configuration around it, overcomes the value of the coercive force of the material there will be local demagnetization zones which will cause deviations in the value of polarization J and, therefore, distortion in the field, which will not correspond any more to design forecasts.

Nonzero susceptivity

A further hypothesis implicitly made in the design methodology for bi-dimensional uniform field magnets has been that of unit permeability material.

Since material susceptivity is defined by:

$$\mu = \mu_0 (1 + X)$$

a condition of unit relative permeability is equivalent to a condition of zero susceptivity.

A material of unit permeability is perfectly "transparent" to magnetic fields, be they generated from its own polarization or by nearby materials or circuits.

If, instead, the material has a relative permeability different from one it will undergo some magnetization because of external magnetic field: as a consequence "magnetic charges" will arise which, in turn, will influence the field. The net result will once more be a deviation with respect to ideal conditions and a corresponding reduction in field homogeneity.

**The slice construction method and its application to finite length magnets.**

The previous description of the state of the art evidenced that, notwithstanding the existence of a general design theory (at least in the areas of the yokeless and hybrid), the practical implementation of finite length, uniform field magnets is adversely affected by the lack of practical means to counteract the field distortion being introduced by the process of reducing the structure to finite length and of realizing it with commercially available, less than ideal materials among which, markedly but not exclusively, its non zero susceptivity.

A further aim of the invention is to provide a procedure for the design and construction which is applicable to any category of magnet described above (yoked, yokeless or hybrid) and which affords remarkable and useful ameliorations both in the practical implementation of the assembly process and in the homogeneity of the field which can be obtained from finite length structures.

**The method fundamentals.**

If, in general, a bi-dimensional structure which would produce, if infinite in length, a perfectly uniform field is truncated then distortion ensue that can be analyzed by expressing the field itself or any equivalent function, like the magnetostatic potential, by means of a series expansion.

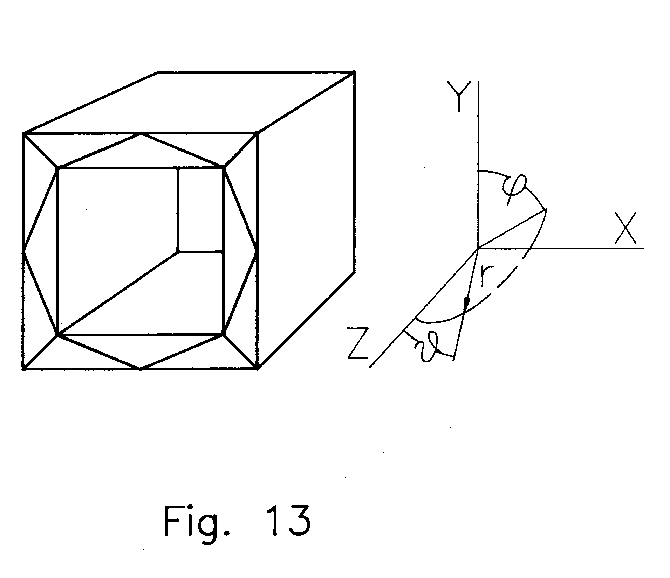

If, with reference to the spherical coordinate system defined in Fig. 13, the spherical harmonics expansion of the magnetostatic potential, within a sphere centered in the magnet center and whose diameter is at most equal to the minimum diameter of the cavity is considered we have:

$\Omega = \text{Re}[A]$

where A is given by:

$$A = \frac{1}{4 \pi \mu_0} \Sigma^{\infty}_{l=1}\Sigma^{l}_{m=1} q_{lm} \; r^l \; P_{lm}(\epsilon) \; e^{jm\Omega}$$

where

$$q_{lm} = 2 \frac{(l-m)!}{(l+m)!} \; \Sigma_i \; \int_{S_i} \sigma_i \; \frac{P_{lm}(\epsilon)}{r^{l+1}} \; e^{jm\Omega}$$

$\epsilon = \cos \theta$, $r = \sqrt{(x^2 + y^2 + z^2)}$ and integrations are extended to all surfaces $S_i$ bearing charges, according to that electrostatic analogy that is often used in magnetostatic problems.

If the structure is such that, if infinite in length, it would generate a uniform field, then the expansion reduces to the term $q_{11}$ alone, giving rise to a uniform field directed along the y axis.

If the structure is truncated to finite length the field will be no more uniform and the spherical harmonics expansion will contain other non zero terms, besides term $q_{11}$.

The integral appearing in the expression giving the $q_{lm}$ coefficients can be expressed as:

$$\int_{S_i} \sigma_i \; \frac{P_{lm}(\epsilon)}{r^{l+1}} \; e^{jm\Omega} = N_i \int J \; t_{lm,i} \; dz$$

where:

J is the material magnetization of the magnetic material

$N_i$ is the cosine of the angle formed by the magnetization vector J and the normal to the surface (such that $\sigma_i = J\,Ni$).

and the functions $t_{lm,i}$ (z,u) are given by:

$$t_{lm,i} \; (z,u) = \int_{L_i} \frac{P_{lm}(\epsilon)}{r^{l+1}} \; e^{-jm\phi} \; dxdy \qquad \left[30\right]$$

the integral is extended to the line $L_i$, intersection of surface $S_i$ with a constant z plane.

By subdividing $L_i$ in a possibly infinite number of sub-intervals and performing a double integration, this approach can be extended to functions $t_{lmi}$ (z,u) where u is x,y or any combination thereof. Only to simplify the notation however, all subsequent examples are referred to z which can be indifferently z,u.

The $t_{lm,i}(z)$ functions which have just been introduced do not have a special physical meaning but are, however, the basis of the new method according to the invention for the practical implementation of finite length two-dimensional magnets.

Imagine, in fact, that the material employed for the magnet manufacture has a magnetization J which is variable along the z coordinate, according to a function J(z). This function J(z) could indifferently be the same for all the magnetized elements or be a different function for any of them. In the following we will assume, without any loss of generality, that the same J(z) function holds for all the elements of the magnet.

One can therefore write:

$$q_{lm} = 2 \frac{(l-m)!}{(l+m)!} \; \Sigma_i \; N_i \int J(z) \; t_{lm,i}(z) \; dz \qquad [31]$$

Assume now the magnet length is finite. Coefficients $q_{lm}$ will be, in general, not null and the corresponding field will not be uniform.

As it was remarked before a uniform magnetic field corresponds to a spherical harmonics expansion in which only the $q_{11}$ term is different from zero.

If the magnet extends from $-Z_0$ to $Z_0$ [31] become:

$$q_{lm} = 2 \ \frac{(l-m)!}{(l+m)!} \ \Sigma_i \ N_i \int_{-Z_0}^{Z_0} J(z) \ t_{lm,i}(z) \ dz \qquad [32]$$

If the function $J(z)$ is chosen such that

$$\int_{-Z_0}^{Z_0} J(z) \ t_{lm,i}(z) \ dz = 0$$

a number at will of $q_{lm}$ coefficients may be zeroed, in particular all coefficient not including $q_{11}$ and up to the order 1 and degree m desired.

The problem of achieving a uniform field is therefore conduced to that of finding a function $J(z)$ orthogonal to functions $t_{lm,i}(z)$ [30] in the interval $-Z_0 \div Z_0$. The problem of the determination of a function which is orthogonal, in a defined interval, to a set possibly infinite of functions is a problem whose solution is known and easily accessible to anyone skilled in the art.

One of the most notable aspects of the invention is therefore the employment of critical functions $t_{lm,i}(z)$ which allow to conduce the problem of the generation of a homogeneous field in finite length (and preferably of the same order of magnitude of the other cavity dimensions) structures to the simple determination of functions orthogonal to other functions over a defined interval.

In fact, for most structures of practical interest, the sum of f.i

$$t_{lm}(z) = \Sigma_i t_{lm,i}(z)$$

of the $t_{lm,i}(z)$ functions has a possibly oscillating but certainly decreasing with z behavior (failing which it would be impossible for the $q_{lm}$ coefficients having l,m different from 1 to vanish as z goes to infinity). One observes a similarly decreasing (with possible oscillations) behavior also for increasing order and degree l and m.

It follows from the above that, given a finite magnet length and having established a target value of homogeneity, there will be an infinite number of coefficients (having order and degree higher than given $l_0$ and $m_0$ values) whose effect on the homogeneity of the field can be deemed to be irrelevant on the established homogeneity target (like the error level LE established in 6b).

As a consequence the process of search for an orthogonal or quasi-orthogonal function is further simplified, being finite the cardinality of the starting set of functions.

Further causes, other than finite length, affect the final field homogeneity as, for instance, the non zero susceptivity of the material. The considerations expressed above can be extended to be applied to the sum of all the contributions brought to any $q_{lm}$ coefficient by a plurality of factors including, in general, any deterministic and therefore computable perturbation cause.

Once the function $J(z)$ which conduces to the desired result has been determined as a function of the prescribed length, field homogeneity, etc. the magnet can be realized by choosing a suitable material for the realization of the different elements making up the magnet.

Were a variable J material not be available it still is possible to employ common constant J material, readily available on the marked and proceed constructing the magnet by juxtaposing thin slices, possibly having varying thickness, between which gaps of non magnetic material are interposed. It is thus possible to obtain a discrete approximation to the desired continuous function $J(z)$.

Operating in this way one has a concrete advantage, even in presence of errors due to the discrete approximation of the continuous function, since the approximation errors can be made less than the combined effect of the above mentioned causes (finite length, non zero susceptivity etc.)

Notice also that, by using the same procedure, one can include also the effect created by additional magnetic structures, chosen so that they generate mainly the kind of distortion (but with opposite sign) that it is mainly expected as an effect of the reduction to finite length. It will just be the matter of adding to the computation of the surface bearing charges also any computation relative to said additional structures and to include then their effect in the process of zeroing the undesired coefficients, in the same fashion of what is done to take into account material imperfections.

The construction of the magnet by juxtaposition of thin slices presents, moreover, further advantages in the manufacturing process, which are conducive to further reductions in the overall cost of the magnet.

**Detailed procedure description**

The following steps describe in detail the process (as represented in the lower part of Fig. 1) which permits the transition from any bi-dimensional structure (be it yoked, yokeless or hybrid) of infinite length to a finite, pre-defined length yielding the desired degree of homogeneity.

6a) Choice of the final finite length LFF of the magnet.

The first step is the definition of the desired length for the magnet. This choice is largely arbitrary and it is mostly determined by the external factors due to magnet foreseen application. It is however to be considered that the more the magnet is shortened the more will homogeneous volume and final resulting field intensity will decrease. It is therefore necessary to make a choice that nears the maximum length that the application allows.

6b) Choice of tolerable error level (e.g. non homogeneity).

The step following the magnet length definition is the definition of the maximum allowable error. What it is meant here by allowable error is maximum deviation from ideal characteristics: allowable error can be defined, at will and according to necessity, e.g. as field homogeneity, potential homogeneity and so on.

Once this choice has been made it must be expressed as a list of limit values (maxima or minima) which are acceptable for the values of the coefficients of the series expansion of the relevant function.

Imagine, by way of example, that the magnetostatic potential has been chosen to define homogeneity: a possible choice of the desired and acceptable level of homogeneity could be expressed in the following way (remember that, in terms of magnetostatic potential a perfectly uniform field would be expressed by a spherical harmonics series expansion having all zero coefficients but coefficient $q_{11}$):

$q_{lm} = 0$ per $l, m < 5$ e $1 > 1$
$q_{51}, q_{52}, q_{54} = 0$
$q_{53}, q_{55} < 10^{-3}$
$q_{71} < 10^{-3}$

In this example, moreover, a structure which is symmetrical with respect to the axes has been imagined: from this it follows that all coefficients having either $l$ or $m$ even are already zero by definition.

6c) Choice of the magnetic material to be employed in the construction and determination of its real characteristics.

The third step involves the selection of a suitable magnetic material to be employed in the magnet construction. The material eventually chosen will, in general, be characterized by definite deviations from ideal behavior. It will, in particular, have non zero susceptivity. If, however, as it happens in practice with most magnetic materials, the susceptivity vale is low, its effect can be described by means of a first order approximation, which only considers those additional charges which arise on the surfaces of the magnetized elements as a consequence of the only "ideal" or zero-order component of the field.

In summary the knowledge of the real characteristics of the material allows the determination of the expectable deviations from ideal in the behavior of the structure.

6d) Definition of the geometry of any compensation structure.

If the deployment of compensating structures is foreseen (which will be chosen so that they generate, at least as a first order approximation, those harmonic components that are to be zeroed, with the appropriate intensity and sign to cancel those originating from the truncation to finite length of the infinite structure) it will be necessary to specify their geometry, thus defining which, among the surfaces which bound them, will bear charges.

7) Computation of the critical functions for the elements making up the magnet and any compensating structure.

The next step consists in the computation (by way of example through a numerical integration of the expressions shown before) of the functions $t_{lm,i}(z)$ which represent the values of the contributions made to qlm coefficients by any surface alone, as a function of distance. It will be convenient to group, by summing them, the functions $t_{lm,i}(z)$ [30] relative to the charges carried by any of the prismatic elements which concur to the magnet formation, thus obtaining functions $t'_{lm,j}(z)$ defined as:

$$t'_{lm,j}(z) = \Sigma_i \, t_{lm,i}(z)$$

where the sum is extended to all charge bearing surfaces belonging to magnetic material element j, be it part of the main structure or of the additional compensation structure.

The effect of material imperfections (as non zero susceptivity) can be either considered directly in the computation of functions $t_{lm,i}(z)$, or by summing to them auxiliary functions $t''_{lm,i}(z)$ obtained considering the charges induced by the polarization subsequent to a non zero susceptivity alone.

8) Determination of the behavior J(z) of the magnetization in the elements making up the magnet and any additional compensating structure.

Once the functions $t'_{lm,j}(z)$ representing the contribution to coefficients $q_{lm}$ from any magnet element, as a function of distance:

$$t'_{lm,j}(z) = \Sigma_i t_{lm,i}(z) = \Sigma_i \int_L \frac{P_{lm}(\epsilon)}{r^{l+1}} e^{-jm\emptyset} \, dxdy$$

where index i runs on every surface making up magnet element having index j
it is possible to determine, for each such element, the necessary behavior of magnetization J along the z axis.

The result can be obtained bay any of the available methods of orthogonalization or parametric minimization. What it is sought is in fact a set of functions $J_j(z)$ satisfying the relationships:

$q_{11}$ = maximum
$q_{rs}$ = 0

where indices r and s run over the values identifying the coefficients to be zeroed

$q_{vw} <= \min_{vw} (> = \max_{vw})$

where indices v and w run over the values identifying the coefficients to be minimized (or maximized)
If the functions $t'_{lm,j}(z)$ have been obtained by means of a numerical integration or are anyway specified in a numerical way over discrete intervals in z the above described problem reduces to a classical linear programming problem which may be solved employing any of the methods available in the current practice.

The result of the above optimization procedure is a set of functions $J_j(z)$: one for each element making up the magnet and the compensating structures and defining a magnet producing a field described by the prescribed coefficients.

9) Magnet construction.

It is now possible proceed to the physical construction of the magnet, assembling the various elements which make it up.

Each and every element, be it part of the main structure or of the compensation structure, is shaped as a finite length prism having a transverse magnetization with a defined direction and variable intensity along the z direction, according to the appropriate $J_j(z)$ function.

The practical realization of such an element can be conveniently effected by means of a laminated construction in which layers of magnetic material are interleaved with non magnetic material layers so as to obtain, for every section along the z coordinate, the desired value of the magnetization. This corresponds, in other words, to go from a continuous representation of the function $J_j(z)$ to a discrete approximation, whose exact approximation degree will be dictated by the normal rules, known to those skilled in the art.

The invention has been described, mainly for the sake of clarity, with reference to the specific realization presented in the drawings: it may obviously be subject to those variations, modifications etc. that, for being in the realm of the skilled technician, naturally fall in the domain and in the spirit of the invention.

**Claims**

1. Permanent magnets for the generation of uniform magnetic fields, in particular for MRI applications and more particularly bi-dimensional magnets preferably yoked having at least an internal cavity (CA), elements of magnetic material generating a field and non magnetic material elements e.g. for compensation, said magnets characterized by having, in a transverse section and inside the cavity, the locus of the zero magnetostatic potential points in the shape of a segment of a substantially straight line cutting the transverse section of said cavity in prescribed positions.

2. Magnets according to claim 1 characterized by a magnetic material thickness substantially zero at least one of the points where said zero magnetostatic potential line inside the cavity meets the boundary of the same cavity.

3. Method for the fabrication of magnets, according to the preceding claims, and characterized at least by the following phases:
   I) selection and possible correlation of m among n base parameters, preferably interconnectable,
   II) definition of the magnetization in the magnetic material,
   III) definition and tracing of the sides (number, length and orientation) constituting the perimeter of the cavity,
   IV) definition and tracing of the total magnet configuration, with the possible introduction of non magnetic material regions and, preferably but not necessarily,
   V) tuning, in particular measures, controls optimizations of the characteristics of the components and of the resulting assembly.

4. Method according to claim 3, characterized by the fact that the m parameters comprise at least the shape of the cavity and the position of the zero potential line.

5. Method according to claim 4, characterized by the fact that the definition of the total configuration of the magnet comprises substantially:
   I) determination of the three vectors B H and J in any magnetic region bounded internally by the corresponding side of the cavity (see, for example, Fig. 8 and Fig. 7b)
   II) determination of the external profile of the magnets in its two sub-phases relating to:
   ■ determination of the sides and/or points of he regions of magnetic material in contact with the inside of the yoke
   ■ determination of the boundaries between the magnetic material regions and the non magnetic material regions and the boundaries between these non magnetic material regions with the inside of the yoke.

6. Method according to at least one of the claims from 3 to 5, characterized by the further phases for the reduction of the magnet length to a finite value:
   ■ (6) definition of m' possible parameters, out of a list of at least n' of them comprising at least:

   final finite length of the magnet;

   error level;

magnetic material;

compensating structure
- (7) computation of functions $t_{lm,i}$ $(z,u)$;
- (8) determination of functions J $(z,u)$; u being x,y or a combination thereof, and
- (9) assembly of the elements and components defined by the values derived from above

7. Permanent finite length magnets for the generation of uniform magnetic field, having a cavity, elements composing the magnet and possibly compensating elements, characterized by thin slices of materials having different magnetization (J) which are chosen, placed and assembled to obtain a function or distribution of the magnetization intensity along at least an axis of the magnet which zeroes one or more terms or the series expansion of the magnetic potential or of an equivalent description of the field.

8. Bi-dimensional magnets, according to claim 7, characterized by the fact that the thin slices are obtained by sectioning ideally through planes perpendicular to said magnet axis bi-dimensional uniform field magnets designed around cavities.

9. Bi-dimensional magnets substantially according to what described and represented.

10. Method for the production of permanent magnets, in particular according to claims 1-2 and/or 7 and 8, substantially according to what said and represented.

| | | | | |
|---|---|---|---|---|
| **1** Selection and correlation of m among n variable and possibly interdependent base parameters | | | | |

1a  1b  1c  1m

| CA | H | LPN | ... | |

| |
|---|
| **2** Determination of the magnetic material magnetization |

Si

CA

PE

| |
|---|
| **3** Trace of the sides (number, length, angulation etc) of the external perimeter |

CT

| |
|---|
| **4** Total configuration CT |

| |
|---|
| **5** Regulation, valuation and optimization |

YLI

INFINITE LENGTH
YOKELESS AND
HYBRID MAGNETS

INFINITE LENGTH
YOKED MAGNETS
YLI

| |
|---|
| **6** Selection and correlation of at least m' among n' variable and possibly inter-dependent base parameters |

6a  6b  6c  6d  6m'

| LFF | LE | MA | COMP | ... | |

| |
|---|
| **7** Calculation of the critical functions $t_{i,j}(z)$ |

| |
|---|
| **8** Determination of magnetization $J(z)$ |

| |
|---|
| **9** Assembling |

MPFF

Fig. 1

18

Fig. 2

Fig. 3a

Fig. 3b

Fig. 4

Fig. 6b

Fig. 6c

Fig. 5

Fig. 6a

Fig. 7a

Fig. 7b

Fig. 8

Fig. 9

Fig. 10

Fig. 11a

Fig. 11b

Fig. 12a

Fig. 12b

Fig. 13

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PHILIPS JOURNAL OF RESEARCH. vol. 40, no. 5, November 1985, EINDHOVEN NL pages 259 - 288; H. ZIJLSTRA: 'Permanent Magnet Systems for NMR Tomography ' | 1,2,10 | H01F7/02 G01R33/38 |
| A | * pages 261 - 266, chapters 3-6 * * pages 270 - 271, chapter 10 * * pages 273 - 283, chapters 12 - 14 * * figure 7 * | 3-6 | |
| X | EP-A-170 318 (N.V. PHILIPS' GLOEILAMPENFABRIEKEN ) | 1-3,10 | |
| A | * page 1, line 19 - page 3, line 9 * * page 5, line 6 - page 7, line 8 * * page 7, line 26 - page 8, line 16 * * figures 2-4 * | 4-9 | |
| D | & US-A-4 695 802 | | |
| X | IEEE TRANSACTIONS ON MAGNETICS. vol. 25, no. 5, September 1989, NEW YORK US pages 3904 - 3906; M.G. ABELE ET AL.: 'Compensation of Non-Uniform Magnetic Properties of Components of a Yokeless Permanent Magnet ' * the whole article * | 1,7 | TECHNICAL FIELDS SEARCHED (Int. Cl.5 ) G01R H01F |
| P,X | WO-A-9 106 963 (NEW YORK UNIVERSITY) * page 4, line 1 - page 5, line 9 * * page 8, line 1 - line 28 * * page 11, line 24 - page 12, line 23 * * page 15, line 7 - page 19, line 1 * * page 23, line 1 - page 24, line 7 * * page 26, line 1 - page 27, line 24 * * claims 1,4 * * figures 1,3,7,9,14-16 * * figures 23,24,26,27 * * figures 34,35 * | 1-5,9,10 | |

The present search report has been drawn up for all claims

| Place of search | Date of completion of the search | Examiner |
|---|---|---|
| THE HAGUE | 10 OCTOBER 1991 | VOLMER W. |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | WO-A-8 802 922 (THOMSON-CGR)<br>* page 1, line 11 - page 3, line 19 *<br>* page 7, line 8 - page 9, line 16 *<br>* figures 4,5 *<br>----- | 7,8,10 | |

TECHNICAL FIELDS SEARCHED (Int. Cl.5)

The present search report has been drawn up for all claims

| Place of search | Date of completion of the search | Examiner |
|---|---|---|
| THE HAGUE | 10 OCTOBER 1991 | VOLMER W. |

EPO FORM 1503 03.82 (P0401)